(19) Europäisches Patentamt
European Patent Office
Office européen des brevets

(11) Veröffentlichungsnummer : **0 372 361 B1**

# (12) EUROPÄISCHE PATENTSCHRIFT

(45) Veröffentlichungstag der Patentschrift :
**18.10.95 Patentblatt 95/42**

(51) Int. Cl.$^6$ : **G03F 7/035**

(21) Anmeldenummer : **89121944.6**

(22) Anmeldetag : **28.11.89**

## (54) Durch Strahlung polymerisierbares Gemisch und daraus hergestelltes Aufzeichnungsmaterial.

(30) Priorität : **06.12.88 DE 3841025**

(43) Veröffentlichungstag der Anmeldung :
**13.06.90 Patentblatt 90/24**

(45) Bekanntmachung des Hinweises auf die Patenterteilung :
**18.10.95 Patentblatt 95/42**

(84) Benannte Vertragsstaaten :
**DE FR GB NL**

(56) Entgegenhaltungen :
**DE-A- 2 404 239**

(56) Entgegenhaltungen :
**DE-A- 3 131 359**
**PATENT ABSTRACTS OF JAPAN, Band 13, Nr. 112 (P-844)[3460], 17. März 1989 & JP-A-63 287 943**

(73) Patentinhaber : **HOECHST AKTIENGESELLSCHAFT**
**D-65926 Frankfurt am Main (DE)**

(72) Erfinder : **Joerg, Klaus, Dr.**
**Winkeler Strasse 2B**
**D-6507 Ingelheim (DE)**
Erfinder : **Zertani, Rudolf, Dr.**
**Hans-Zöller-Strasse 111**
**D-6500 Mainz-Laubenheim (DE)**



Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

## Beschreibung

Die Erfindung betrifft ein durch Strahlung, insbesondere ultraviolettes oder sichtbares Licht, polymerisierbares Gemisch, das ein wasserunlösliches, in wäßrig-alkalischen Lösungen lösliches Bindemittel, eine radikalisch polymerisierbare Verbindung und einen durch Strahlung aktivierbaren Polymerisationsinitiator für die polymerisierbare Verbindung enthält, sowie ein Aufzeichnungsmaterial mit einer Aufzeichnungsschicht aus dem genannten Gemisch.

Strahlungs- und photopolymerisierbare Gemische der angegebenen Gattung sind bekannt. Sie enthalten als alkalilösliche Bindemittel z. B. Copolymere der Acryl- oder Methacrylsäure, der Malein-, Croton- oder Itaconsäure mit neutralen Comonomeren, z. B. Estern der (Meth)acrylsäure, Styrol, Vinylacetat oder (Meth)acrylnitril. Derartige Gemische sind u. a. in den DE-A 20 64 080 und 22 05 146 beschrieben. Sie werden im allgemeinen zur Herstellung von Hoch- und Flachdruckplatten und von Photoresists eingesetzt, insbesondere solchen, die nach dem Trockenresistverfahren verarbeitet werden.

Für die Herstellung von Flachdruckplatten ist es wesentlich, daß die strahlungs- bzw. lichtgehärtete Schicht eine hohe Abriebbeständigkeit aufweist, um hohe Druckauflagen zu liefern. Für diese Eigenschaft ist in erster Linie das polymere Bindemittel maßgeblich. Es ist für Flachdruckplatten auf Basis von negativ arbeitenden Diazoniumverbindungen z. B aus der DE-A 27 39 774 bekannt, daß mit Polyurethanen als Bindemittel Druckformen mit hoher Auflagenleistung erhalten werden. ES werden auch photopolymerisierbare Gemische mit solchen Polymeren als Bindemittel beschrieben. Der Nachteil von derartigen Schichten liegt in der schlechten Löslichkeit in wäßrigen Lösungen, ein hoher Anteil an Lösungsmittel im Entwickler ist deshalb, wie in der EP-A 0 072 918 oder der DE-A 24 04 239 beschrieben, für eine vollständige Entwicklung notwendig. Durch den Einbau quaternärer oder quaternisierbarer Stickstoffatome in ein hochmolekulares thermoplastisches Polyurethan mit seitenständigen ungesättigten, photopolymerisierbaren Doppelbindungen können, wie in der EP-A 0 054 150 beschrieben, photopolymerisierbare Aufzeichnungsmaterialien erhalten werden, die mit schwach sauren wäßrigen Lösungen entwickelbar sind. Der Nachteil der Druckschichten, die solche Bindemittel enthalten, besteht in der schlechten Resistenz gegenüber den im konventionellen Offsetdruck verwendeten sauren Wischwässern, da Polyurethane mit basischen Stickstoffatomen im sauren Medium löslich oder zumindest stark quellbar sind. Weit günstiger sind photopolymerisierbare Schichten, die in alkalischen Entwicklern ohne einen Lösungsmittelzusatz entwickelbar sind.

Die japanische Anmeldung JP-A 54/14491 (C.A. 92, 32017b) beschreibt die Umsetzung carboxylgruppenhaltiger Polyester mit monofunktionellen ungesättigten Isocyanaten. Die Zahl der Urethangruppen pro Molekül, die dem System die guten Eigenschaften wie Abriebfestigkeit verleihen, ist hierbei sehr begrenzt.

Aus der DE-A 31 07 585 ist bekannt, für die Herstellung von Druckplatten ungesättigte, carboxylgruppenhaltige Polyurethane einzusetzen, die durch die Umsetzung eines NCO-terminierten Präpolymeren mit einem ethylenisch ungesättigten Diol und anschließende Reaktion der noch verbleibenden OH-Gruppen mit einem cyclischen Carbonsäureanhydrid entstehen. In der GB-A 2 091 278 wird der Einsatz von Polyurethanen, die an einem Ende eine Carbonsäuregruppe, am anderen eine ethylenisch ungesättigte Gruppe enthalten, für die Herstellung von Photoresists beschrieben. Die Nachteile der in diesen Schriften angegebenen Polymeren ist der geringe Gehalt an Carbonsäuregruppen pro Molekül, was sich bei höheren Molekulargewichten in einer schlechten Alkalilöslichkeit der Schichten bemerkbar macht.

Aus der DE-A 36 39 757 sind Carboxylgruppen enthaltende Polyurethane bekannt, die in Kombination mit Diazoniumsalzen in lichtempfindlichen Gemischen eingesetzt werden. Abgeleitet von diesen Polymeren werden in der DE-A 37 16 607 Polyurethane beschrieben, die zusätzlich zu den Carboxylgruppen ungesättigte Gruppierungen, die lichtvernetzbar sind, enthalten. Diese Polymeren können allein oder in Kombination mit Monomeren oder Diazoniumsalzen in Druckplatten eingesetzt werden. Für die Entwicklung der Druckschichten wird ein Entwickler verwendet, der 3 % Benzylalkohol enthält.

In der JP-A 61/20939 (C.A. 105, 52221d) werden Polyurethane mit Carboxylgruppen beschrieben, die durch Umsetzung eines Präpolymeren, hergestellt aus einem Polypropylenglykol und einem Überschuß Tolylendiisocyanat, mit dem Monoamid aus Diethanolamin und Bernsteinsäureanhydrid entstehen. Nach der Herstellung werden die Carbonsäuregruppen mit Dimethylamin neutralisiert und dabei gleichzeitig noch vorhandene endständige NCO-Gruppen deaktiviert. Die Harze werden in Kombination mit einem Methacrylsäure/Methacrylat-Copolymeren, einem monomeren polymerisierbaren Acrylat, einem Photoinitiator und einem Farbstoff als lichtempfindliche Schicht in Druckplatten eingesetzt.

Der wesentliche Nachteil dieser Bindemittel ist die lange Reaktionszeit bei ihrer Synthese. Da bei der Herstellung der Polyurethane Carbonsäuregruppen, die die Lösung sauer stellen, vorhanden sind, wird die Reaktionsgeschwindigkeit der NCO-Gruppen mit OH-Gruppen stark herabgesetzt (vgl. G.W. Becker und D. Braun, Kunststoffhandbuch, Band 7, Carl Hanser Verlag, München 1983). Mit fortschreitendem Umsatz nimmt die Reaktionsgeschwindigkeit zusätzlich ab. Zum Erreichen eines hohen Molekulargewichtes ist jedoch eine möglichst weitgehende Umsetzung notwendig. Dies ist hierbei nur durch extrem lange Reaktionszeiten erreichbar. Eine Verringerung der Reaktionszeit (vorzeitiger Abbruch der Reaktion durch Dimethylamin) führt zu kurzkettigen Polyurethanen, die Druckplatten mit schlechten mechanischen Eigenschaften ergeben; außerdem sind die Schichten im unbelichteten Zustand of klebrig.

Aus den US-A 4 183 836 und 4 203 883 ist bekannt, stabile wäßrige anionische Polyurethandispersionen zur Beschichtung von textilem Material über ein Präpolymeres herzustellen. Hierzu wird zunächst ein Carboxylgruppen enthaltendes, NCO-terminiertes Präpolymeres synthetisiert; die Säuregruppen werden anschließend in einer wäßrigen Lösung eines tertiären Amins neutralisiert und die NCO-Gruppen mit einem Diamin als Kettenverlängerer umgesetzt. Das Verfahren ist auf bestimmte, meist aliphatische Diisocyanate beschränkt, die nur langsam mit Wasser reagieren. Von einer Eignung als Bindemittel für lichtempfindliche Gemische wird nichts erwähnt.

In der JP-A 63/287 943 sind lichtempfindliche Gemische beschrieben, die polymerisierbare Monomere, Photopolymerisationsinitiatoren und - als Bindemittel - Carboxylgruppen enthaltende Polyurethane mit Harnstoffgruppen in der Polymerkette enthalten.

Aufgabe der Erfindung war es, ein durch Strahlung, insbesondere Licht, polymerisierbares Gemisch, das zur Herstellung von Photoresists und Druckplatten, insbesondere Flachdruckplatten geeignet ist, vorzuschlagen, das Schichten mit geringer Klebrigkeit im unbelichteten und belichteten Zustand bildet, das sich leicht mit umweltfreundlichen wäßrigen Lösungen verarbeiten läßt und Bildschablonen mit hoher Resistenz gegen Lösemittel und Chemikalien und hoher Abriebbeständigkeit ergibt.

Erfindungsgemäß wird ein durch Strahlung polymerisierbares Gemisch vorgeschlagen, das als wesentliche Bestandteile

a) ein gesättigtes Polymeres mit wiederkehrenden Urethangruppen und Harnstoffgruppen in der Hauptkette, das
   α) Einheiten, die aus einem Carboxylgruppen enthaltenden Diol,
   β) Einheiten, die aus einem Diamin und
   γ) Einheiten enthält, die aus einem Diisocyanat entstanden sind,

b) eine radikalisch polymerisierbare Verbindung mit mindestens einer end-ständigen ethylenischen Doppelbindung und einem Siedepunkt oberhalb 100 °C bei Normaldruck und

c) eine Verbindung oder eine Verbindungskombination enthält, die unter Einwirkung von aktinischer Strahlung die Polymerisation der Verbindung (b) zu initiieren vermag.

Das erfindungsgemäße Gemisch ist dadurch gekennzeichnet, daß die Diamineinheiten von einem Polyether- oder Polyesterdiamin abgeleitet sind.

Erfindungsgemäß wird ferner ein durch Strahlung polymerisierbares Aufzeichnungsmaterial mit einem Schichtträger und einer durch Strahlung polymerisierbaren Schicht vorgeschlagen, das dadurch gekennzeichnet ist, daß die Schicht aus dem vorstehend definierten Gemisch besteht.

Die in dem erfindungsgemäßen Gemisch eingesetzten Polyurethane sind gesättigte Verbindungen, d. h. sie enthalten keine aliphatischen C-C-Doppelbindungen, insbesondere keine polymerisierbaren oder vernetzbaren Gruppen. Sie werden hergestellt durch Umsetzen eines Carboxylgruppen enthaltenden Diols mit einem Diisocyanat zu einem Präpolymeren mit endständigen NCO-Gruppen und Umsetzung des Präpolymeren mit Diaminen zu einem hochmolekularen, Carboxyl- und Harnstoffgruppen enthaltenden Polyurethan.

Obwohl die Polymeren vorzugsweise ausschließlich aus bifunktionellen Reaktionspartnern hergestellt werden, ist es möglich, auch kleinere Mengen an mehrfunktionellen Verbindungen zuzusetzen. So können zur Herstellung des Präpolymeren bis zu etwa 10, vorzugsweise nicht mehr als 5 mol-% Triole oder Triisocyanate, jeweils bezogen auf die Gesamtmolmenge an mehrwertigem Alkohol bzw. mehrwertigem Isocyanat, zugesetzt werden, um in begrenzter Menge Verzweigungsstellen in das Polymermolekül einzuführen. Das gleiche kann durch Zusatz entsprechender Mengen an Triaminen zum Diamin erreicht werden. Die Reaktionsprodukte sind vorzugsweise linear, und die Menge an trifunktionellen Verbindungen darf keinesfalls so hoch sein, daß schon in wesentlicher Menge vernetzte Strukturen gebildet werden, die das Polymere in unerwünschtem Maße un- oder schwerlöslich machen und damit zu gelartigen Produkten führen.

Die bei der Umsetzung eingesetzten Diisocyanate können aliphatischer oder aromatischer Natur sein. Dabei ist zu beachten, daß aliphatische Diisocyanate im allgemeinen langsamer reagieren als aromatische, d. h. mit den letzteren in kürzeren Reaktionszeiten hochmolekulare Produkte erhalten werden können. Andererseits ergeben längerkettige (z. B. $C_6$ bis $C_{14}$) aliphatische Diisocyanate im allgemeinen Produkte, die weniger spröde sind als die aus rein aromatischen Diisocyanaten. Der die beiden NCO-Gruppen tragende Rest hat im allgemeinen 2 bis 20, vorzugsweise 6 bis 15 Kohlenstoffatome und kann ggf. Ether-, Ester-, Urethan-, Amido-, Ureidogruppen oder Halogenatome als Substituenten tragen.

Beispiele für geeignete Diisocyanate sind: 2,4-Tolylendiisocyanat, 2,6-Tolylendiisocyanat, p-Xylylendiisocyanat, 4,4′-Diphenylmethandiisocyanat, 1,5-Naphthalindiisocyanat, 4,4′-Biphenyldiisocyanat, 2,2-Bis-(4-Isocyanato-phenyl)propan, Ethylendiisocyanat, n-Butylendiisocyanat, Hexamethylendiisocyanat, 2,4,4-Trimethyl-hexamethylendiisocyanat, Lysindiisocyanat, Isophorondiisocyanat, Cyclohexandiisocyanat und Bis-(4-Isocyanato-cyclohexyl)methan.

Als Diole können ebenfalls aromatische und aliphatische sowie gemischt aliphatisch-aromatische Verbindungen eingesetzt werden, die monomer oder oligomer sein können. Bevorzugt werden Diole der allgemeinen Formel I

$$\begin{array}{l} R^{3}OH \\ | \\ Y - R^{4} - COOH \qquad\qquad (I) \\ | \\ R^{2}OH \end{array}$$

in der Y ein Stickstoffatom oder eine der Gruppen Ar und C-$R^1$; $R^1$ ein Wasserstoffatom, eine substituierte oder unsubstituierte Alkyl-, Aralkyl-, Aryl-, Alkoxy- oder Aryloxygruppe, vorzugsweise ein Wasserstoffatom, eine Alkylgruppe mit 1 bis 8 Kohlenstoffatomen oder eine Arylgruppe mit 6 bis 15 Kohlenstoffatomen; $R^2$, $R^3$ und $R^4$, die untereinander gleich oder verschieden sein können, Einfachbindungen, substituierte oder unsubstituierte Alkylen-, Alkylencarbonyl-, Arylen- oder gemischte aliphatisch-aromatische zweiwertige Kohlenwasserstoffgruppen, vorzugsweise Einfachbindungen, Alkylen- oder Alkylencarbonylgruppen mit 1 bis 8 Kohlenstoffatomen; und Ar eine substituierte oder unsubstituierte dreiwertige aromatische Gruppe, vorzugsweise mit 6 bis 12 Kohlenstoffatomen bedeuten. Wenn Y = N ist, können $R^2$, $R^3$ und $R^4$ keine Einfachbindungen sein.

Als Substituenten kommen insbesondere Halogenatome, Cyano-, Nitro-, Carboxyl-, Acyl-, Amido-, Ester-, Ether-, Ureido- oder Urethangruppen in Betracht. Auch können die Kohlenwasserstoffreste durch Ethersauerstoffatome, Carbonyl-, Ester-, Säureamid-, Urethan- oder Harnstoffgruppen unterbrochen sein. Gegebenenfalls können jeweils zwei der Gruppen $R^1$, $R^2$, $R^3$ und $R^4$ untereinander unter Ringbildung verbunden sein.

Beispiele für geeignete Carboxylgruppen enthaltende Diole sind 3,5-Dihydroxy-benzoesäure, 2,2-Bis-hydroxymethyl-propionsäure, 2,2-Bis-hydroxyethyl-propionsäure, 2,2-Bis-(3-hydroxy-propyl)-propionsäure, Bis-hydroxymethyl-essigsäure, Bis-(4-hydroxyphenyl)-essigsäure, 2,2-Bis-(4-hydroxyphenyl,-pentansäure, Weinsäure und dgl.

Neben den vorstehend beschriebenen, Carboxylgruppen enthaltenden Diolen können auch neutrale Diole, die keine Carboxylgruppen enthalten, zugesetzt werden, um die gewünschte Säurezahl des Polymeren einzustellen. Diese neutralen Diole können niedermolekular oder höhermolekular und Polyether- oder Polyesterdiole sein. Mit besonderem Vorteil werden Polyetherdiole, insbesondere mit Molgewichten von 200 bis 3000, eingesetzt. Durch den Einbau dieser Komponente wird das Molekulargewicht des Endprodukts in gewünschter Weise erhöht; die Säurezahl läßt sich steuern, und die Polyethersequenzen erhöhen die Löslichkeit in rein wäßrigen Entwicklerlösungen, so daß man zum Erreichen der Alkalilöslichkeit nur relativ niedrige Säurezahlen benötigt. Das Molgewicht der Polyetherdiole darf jedoch bei kurzen Oxyalkyleneinheiten, z. B. bei Polyethylenoxiden, nicht zu hoch gewählt werden, weil sonst die Farbannahme der lichtgehärteten Schicht beim Flachdruck verschlechtert wird.

Beispiele für geeignete Diole sind Ethylenglykol, Diethylenglykol, Triethylenglykol, Polyethylenglykole mit Molgewichten von 200 bis 500, Propylenglykol, Tripropylenglykol, Polypropylenglykole mit Molgewichten von 200 bis 2000, Ethylenoxid-Propylenoxid-Copolymere, Neopentylglykol, 1,4-Butandiol, Polybutandiole mit Molgewichten von 200 bis 2000, 1,6-Hexandiol, 2,2,4-Trimethy1-1,3-pentandiol, Cyclohexandimethanol und Umsetzungsprodukte von Ethylenoxid oder Propylenoxid mit Bisphenol A.

Als Polyesterdiole sind solche aus Dicarbonsäuren und Diolen mit Molekulargewichten im gleichen Bereich wie die Polyetherdiole geeignet. Als Diole können die oben genannten Verbindungen eingesetzt werden; geeignete Dicarbonsäuren sind z. B. Oxal-, Glutar-, Adipin-, Phthal- und Terephthalsäure.

Die Harnstoffgruppen werden in die Polyurethane eingeführt, indem die Präpolymeren mit endständigen NCO-Gruppen weiter mit Diaminen umgesetzt werden. Als Diamine werden aliphatische oder aromatische Verbindungen mit primären oder sekundären Aminogruppen eingesetzt. Die die beiden Aminogruppen verbindende Gruppe ist eine Polyether- oder Polyestergruppe der oben beschriebenen Natur. Als weiteren Substituenten können die Stickstoffatome jeweils eine Alkylgruppe, bevorzugt mit 1 bis 8 Kohlenstoffatomen tragen.

Zur Herstellung der in den erfindungsgemäßen Gemischen eingesetzten Polyurethane wird in einer ersten Stufe das Diisocyanat mit dem Carboxylgruppen enthaltenden Diol und bevorzugt einem weiteren, von Carboxylgruppen freien Diol umgesetzt. Die Umsetzung erfolgt normalerweise in einem aprotischen Lösemittel

in Gegenwart eines üblichen basischen Katalysators bei einem Überschuß von NCO-Gruppen gegenüber OH-Gruppen. Das bevorzugte Verhältnis von NCO zu OH liegt im Bereich von 1,01 bis 5 : 1. Das Mengenverhältnis und die Reaktionsbedingungen werden so gewählt, daß ein Präpolymeres mit relativ niedrigem Molekulargewicht gebildet wird, so daß diese Reaktion innerhalb weniger Stunden beendet ist. In einer zweiten Stufe wird dann das erhaltene Präpolymere mit dem oben genannten Diamin zu einem hochmolekularen Polymeren mit Urethan- und Harnstoffgruppen in der Hauptkette und seitenständigen Carboxylgruppen umgesetzt. Diese Reaktion verläuft spontan ohne zusätzlichen Katalysator, d. h. sie führt auch bei den höhermolekularen Ausgangsstoffen zu einem vollständig umgesetzten hochmolekularen Endprodukt innerhalb ausreichend kurzer Reaktionszeiten, d. h. im allgemeinen von wenigen Stunden. Das in der zweiten Stufe eingesetzte Äquivalentverhältnis von NCO : NH liegt im allgemeinen im Bereich von 0,5 bis 1 : 1.

Das Äquivalentverhältnis von Harnstoff- zu Urethangruppen im fertigen Polymeren liegt im allgemeinen im Bereich von 1 : 99 bis 95 : 5, bevorzugt von 5 : 95 bis 80 : 20 und insbesondere von 5 : 95 bis 30 : 70.

Durch das beschriebene zweistufenverfahren ist es möglich, hochmolekulare, Carboxylgruppen enthaltende Polyurethane zu erhalten. Die Bildung von Urethanen aus NCO- und OH-Gruppen verläuft im sauren Medium, also auch in Gegenwart von Carboxylgruppen, relativ langsam, wie es in der eingangs genannten Veröffentlichung von Becker und Braun beschrieben ist. Die erste Reaktionsstufe führt deshalb nur zu relativ niedermolekularen Präpolymeren, die dann in der zweiten Stufe durch die rasch verlaufende Umsetzung von NCO-Gruppen mit Aminogruppen innerhalb relativ kurzer Zeit zu hochmolekularen Produkten umgesetzt werden können.

Die Polyharnstoffurethane haben im allgemeinen ein mittleres Molekulargewicht $M_w$ von mehr als 1000, vorzugsweise von 10.000 bis 200.000. Die Säurezahl der Polymeren liegt im Bereich von 1 bis 350, vorzugsweise von 5 bis 200 und insbesondere von 20 bis 150. Die niederen Säurezahlen reichen dann für eine rein wäßrig-alkalische Entwicklung noch aus, wenn die Polymeren, wie oben erwähnt, noch wesentliche Anteile an hydrophilen Polyethersequenzen enthalten.

Die erfindungsgemäßen Gemische enthalten außer den beschriebenen Polymeren noch ethylenisch ungesättigte polymerisierbare Verbindungen, durch aktinische Strahlung, insbesondere durch ultraviolettes oder sichtbares Licht aktivierbare Polymerisationsinitiatoren und ggf. weitere übliche Bestandteile photopolymerisierbarer Gemische.

Als Bindemittel können sie neben den oben beschriebenen Polyurethanen andere übliche Polymere in kleineren Mengen bis zu etwa 50 %, bezogen auf die Polyurethane, enthalten. Geeignet sind z. B. Polyamide, Epoxyharze, Homo- und Copolymerisate von Acryl- und Methacrylsäureestern, Polyvinylacetale, Polyvinylacetate und Polystyrole.

Als polymerisierbare Monomere kommen Verbindungen mit mindestens einer ungesättigten Doppelbindung in Betracht. Als Beispiele für monofunktionelle Verbindungen sind langkettige substituierte und unsubstituierte Alkyl- oder Alkoxyalkylester der Methacrylsäure und Acrylsäure zu nennen, wie sie beispielsweise in der EP-A 128 014 beschrieben sind. Weiterhin lassen sich vorteilhaft Monomere mit Urethangruppen einsetzen. Beispiele dafür finden sich in der DE-A 35 40 480.

Die erfindungsgemäßen Gemische enthalten vorzugsweise mindestens zum Teil polymerisierbare Verbindungen mit mindestens zwei endständigen ethylenischen Doppelbindungen. Als derartige polymerisierbare Verbindungen werden im allgemeinen Ester der Acryl- oder Methacrylsäure mit mehrwertigen, vorzugsweise primären, Alkoholen verwendet. Beispiele für geeignete mehrwertige Alkohole sind Ethylenglykol, Propylenglykol, Butandiol-1,4, Butandiol-1,3, Diethylenglykol, Triethylenglykol, Polyethylenglykole oder Polypropylenglykole mit Molekulargewichten von etwa 200 bis 1.000, Neopentylglykol, Trimethylolethan und -propan, Pentaerythrit und oxyethylierte Bisphenol-A-Derivate.

Als durch Strahlung, insbesondere aktinisches Licht aktivierbare Polymerisationsinitiatoren in dem erfindungsgemäßen Gemisch können eine Vielzahl von Substanzen Verwendung finden. Beispiele sind Benzoin und seine Derivate, Mehrkernchinone, Trichlormethyl-s-triazine, Trihalogenmethylgruppen enthaltende Carbonylmethylenheterocyclen, z. B. 2-(p-Trichlormethyl-benzoylmethylen)-3-ethyl-benzthiazolin, Acridinderivate, z. B. 9-Phenyl-acridin, 9-p-Methoxy-phenyl-acridin, 9-Acetylamino-acridin, Benz(a)acridin; Phenazinderivate, z. B. 9,10-Dimethyl-benz(a)phenazin, 10-Methoxy-benz(a)phenazin, Chinoxalinderivate, z. B. 6,4′,4″-Trimethoxy-2,3-diphenylchinoxalin, 4′,4″-Dimethoxy-2,3-diphenyl-5-azachinoxalin oder Chinazolinderivate. Die Initiatoren werden allgemein in einer Menge von 0,01 bis 10, vorzugsweise von 0,1 bis 8 Gew.-%, bezogen auf die nicht flüchtigen Bestandteile des Gemisches, eingesetzt.

Das erfindungsgemäße Gemisch enthält im allgemeinen 30 bis 90, bevorzugt 40 bis 85, Gew.-% Bindemittel und 5 bis 70, bevorzugt 10 bis 60, Gew.-% polymerisierbare Verbindungen, bezogen jeweils auf die Gesamtmenge an nicht flüchtigen Bestandteilen.

Das Gemisch kann als übliche weitere Bestandteile Polymerisationsinhibitoren, Wasserstoffdonatoren, Lichtempfindlichkeitsregler, Farbstoffe, Pigmente, Weichmacher und thermisch aktivierbare Vernetzungsmittel enthalten.

Zur Erzielung eines Farbumschlags in den belichteten Bereichen der Schicht werden dem Gemisch Verbindungen zugesetzt, die mit sauren Photolyseprodukten, z. B. von Trichlormethylgruppen enthaltenden Photoinitiatoren, reagieren und dabei einen Farbumschlag bewirken. Beispiele für solche Kontrastmittel sind einfache primäre und sekundäre aromatische Amine, aber auch Leucofarbstoffe, z. B. Diphenylamin, Dibenzylamin, Triphenylamin, Diethylanilin, Diphenyl-p-phenylendiamin, p-Toluidin, 4,4′-Diamino-diphenyl, o-Chloranilin, o-Bromanilin, 4-Chlor-o-phenylendiamin, o-Brom-N,N-dimethylanilin, 1,2,3-Triphenylguanidin, Naphthylamine, Diaminodiphenylmethan, Anilin, 2,5-Dichloranilin, N-Methyldiphenylamin, 4,4′-Bis-dimethylamino-diphenylmethan, N,N-Dimethyl-p-phenylendiamin, 1,2-Dianilinoethylen, 4,4′,4″-Triamino-o-methyltriphenylmethan, 4,4′,4″-Triamino-triphenylcarbinol und Kristallviolett-Leucobase.

Die erfindungsgemäßen Gemische lassen sich auf bekannte Weise entsprechend ihrem Anwendungszweck zu lichtempfindlichen Materialien verarbeiten. Als Lösemittel oder Lösemittelgemisch, aus dem die Beschichtung erfolgt, können z. B. Propylenglykolmonomethylether, Ethylenglykolmonomethylether, Ethylenglykolmonoacetat, Dioxan, Tetrahydrofuran, Butylacetat, Butanon usw. verwendet werden. Zur Weiterverarbeitung werden die erhaltenen Lösungen filtriert, um gegebenenfalls ungelöste Bestandteile zu entfernen, und in an sich bekannter Weise, z. B. durch Rakeln oder Schleudern, auf ein geeignetes Trägermaterial aufgetragen und getrocknet. Als Trägermaterialien sind z. B. Aluminium, welches mechanisch oder elektrochemisch aufgerauht und ggf. anodisiert und nachbehandelt worden ist, aluminiumkaschierte oder andersartig hydrophilierte Folien, kupferbedampfte Folien oder Mehrmetallfolien geeignet. Die Art des Auftrags hängt in hohem Maß von der gewünschten Schichtdicke der lichtempfindlichen Schicht ab.

Diese Schicht wird nach dem Trocknen bevorzugt mit einer Deckschicht, die als Sauerstoffbarriere wirkt, überzogen. Diese kann bevorzugt aus einem Material bestehen, das sich in der Entwicklerflüssigkeit löst oder mindestens an den nichtgehärteten Stellen bei der Entwicklung entfernen läßt. Hierfür geeignete Materialien sind z. B. Wachse, Polyvinylalkohol, Polyphosphate, Zucker usw.

Nach ausreichender Trocknung können die Materialien in an sich bekannter Weise durch bildmäßige Belichtung mitels einer Negativ-Filmvorlage in ihre jeweilige Anwendungsform überführt werden. Die bildmäßig belichteten Platten werden vorzugsweise mit einem rein wäßrigen Entwickler entwickelt. Die Entwicklerlösung kann dabei Tenside und alkalische Puffersubstanzen wie Natriumsilikat oder Natriumphosphate enthalten.

Die erfindungsgemäßen Gemische erlauben die Herstellung von Flachdruckformen, die sich durch verhältnismäßig hohe Auflagenleistungen, gutes Kopierverhalten und hohe Lagerstabilität auszeichnen. Sie lassen sich leicht und schleierfrei mit Entwicklerlösungen, die frei von orga-nischen Lösemitteln sind, entwickeln. Gegenüber vergleichbaren bekannten Druckplatten auf Polyurethanbasis zeigen sie eine höhere Druckauflage, geringere Klebrigkeit, eine deutlich höhere Lichtempfindlichkeit und eine steilere Gradation.

Im folgenden werden Beispiele zur Erläuterung bevorzugter Ausführungsformen des erfindumgsgemäßen Gemischs und Materials angegeben. Darin sind Mengenverhältnisse und Prozentzahlen, wenn nichts anderes angegeben ist, in Gewichtseinheiten zu verstehen. Die Mengen in den Anwendungsbeispielen sind in Gewichtsteilen (Gt) angegeben. Es werden zunächst Herstellungsbeispiele für die Polyurethane angegeben; das Herstellungsbeispiel 1 beschreibt die Herstellung eines Polyurethans gemäß JP-A 61/20 939. Alle Umsetzungen der Synthesebeispiele wurden unter Stickstoff ausgeführt.

<u>Synthesebeispiel 1</u> (Vergleichsbeispiel)

In einem 250 ml fassenden Dreihalskolben wurden 17,8 g Polypropylenglykol (M = 480), 0,24 g Toluolsulfonylisocyanat und 150 g wasserfreies Tetrahydrofuran 15 Minuten gerührt. Anschließend wurden 13,0 g Tolylen-2,4-diisocyanat und 0,17 g Dibutylzinndilaurat zugegeben und das Gemisch eine Stunde unter Rückfluß gekocht und die erhaltene Lösung zu einer Mischung aus 7,6 g des Monoamids aus 1 mol Bernsteinsäureanhydrid und 1 mol Diethanolamin in 184 g Tetrahyorofuran getropft und 22 Stunden unter Rückfluß erhitzt, bis kein Isocyanat in der Lösung mehr vorhanden war. Mit Hilfe der Gelpermeationschromatographie (Polystyrolstandard) wurde ein Gewichtsmittel des Molekulargewichts ($M_w$) von 8500 bestimmt.

Die Säurezahl betrug 54 mg KOH/g Substanz.

<u>Synthesebeispiel 2</u>

In einem 250 ml fassenden Dreihalskolben wurden 16,1 g Polypropylenglykol (M = 480), 65,7 g wasserfreies Tetrahydrofuran und 0,22 g Toluolsulfonylisocyanat 15 Minuten gerührt. Anschließend wurden 13 g Tolylen-2,4-diisocyanat und 0,17 g Dibutylzinndilaurat zugegeben und das Gemisch zwei Stunden unter Rückfluß erhitzt. Anschließend wurden 6,9 g des Additionsprodukts aus 1 mol Bernsteinsäureanhydrid und 1 mol Diethanolamin zugegeben und weitere zwei Stunden unter Rückfluß gekocht. Danach wurde die Lösung mit

42,2 g Tetrahydrofuran verdünnt und tropfenweise mit 1,95 g Polyoxypropylendiamin (M = 420) in 42,2 g Tetrahydrofuran versetzt.

Die Säurezahl des Polymeren betrug 48. Die Gelpermeationschromatographie ergab ein Molekulargewicht ($M_w$) von 27.000 (Polystyrolstandard).

Synthesebeispiel 3

In einem 1000 ml fassenden Dreihalskolben wurden 76 g Polypropylenglykol (M = 480), 21,3 g 2,2-Bishydroxymethyl-propionsäure und 260 g Tetrahydrofuran (wasserfrei) eingewogen und mit 1,25 g Toluolsulfonylisocyanat versetzt. Die Suspension wurde 15 Minuten gerührt, anschließend wurden 75 g Naphthalin-1,5-diisocyanat und 1g Dibutylzinndilaurat zugegeben und 8 Stunden unter Rückfluß erhitzt. Nach dem Abkühlen auf Raumtemperatur wurde zur Kontrolle der Isocyanatgehalt bestimmt. Dazu wurde eine Probe des Präpolymeren mit einer überschüssigen Menge an Dibutylamin versetzt, und nach 15 Minuten Stehen wurde das nicht abreagierte Dibutylamin mit Salzsäure zurücktitriert. Das Präpolymere wurde mit 250 g Tetrahydrofuran (wasserfrei) verdünnt und tropfenweise mit einer Lösung aus 15,3 g Polyoxypropylendiamin (M = 420) und 247 g Tetrahydrofuran versetzt.

Die erhaltene 30 %ige Polymerlösung kann direkt zur Beschichtung eingesetzt werden. Für analytische Zwecke wurden 100 g der Polymerlösung in 1 Liter einer 1 %igen wäßrigen Ammoniaklösung aufgelöst, und durch Ansäuern mit 10 %iger Salzsäure wurde daraus das Polymere ausgefällt. Es wurde über eine Glasfritte filtriert, mit Wasser gewaschen und im Vakuum getrocknet. Es wurden 25 g (83 %) des Polymeren mit der Säurezahl 51 isoliert. Mit Hilfe der Gelpermeationschromatographie (Polystyrolstandard) wurde das Molekulargewicht $M_w$ = 30.000 bestimmt.

Synthesebeispiele 4 bis 13

In gleicher Weise wie im Beispiel 3 wurden die Polymeren in den Beispielen 4 bis 13 hergestellt (vgl. Tab. 1). Die titrierten Säurezahlen stimmten mit den theoretisch berechneten überein. Die Molgewichte $M_w$ der ausgefällten Polymeren lagen im Bereich von 20.000 bis 40.000 (Polystyrolstandard). Die Reaktionszeiten lagen in Abhängigkeit vom eingesetzten Isocyanat und der Menge der Dihydroxycarbonsäure im Bereich von 1,5 bis 35 Stunden.

Tabelle 1 (Die Zahlenangaben entsprechen Gew.-%)

| Synthesebeispiel | 3 | 4 | 5 | 6 | 7 | 8 | 9 | 10 | 11 | 12 | 13 |
|---|---|---|---|---|---|---|---|---|---|---|---|
| Tolylen-2,4-diisocyanat | - | 35,37 | 36,56 | - | - | - | - | - | 42,4 | - | - |
| Diphenylmethan-4,4'-diisocyanat | - | - | - | - | 33,31 | - | - | - | - | - | 32,78 |
| Hexamethylendiisocyanat | - | - | - | - | - | - | 41,49 | | | | |
| Isophorondiisocyanat | - | - | - | - | - | 41,74 | - | - | - | - | - |
| Dicyclohexylmethan-4,4'-diisocyanat | - | - | - | 52,15 | - | - | - | 53,01 | - | 44,98 | - |
| Naphthalin-1,5-diisocyanat | 39,89 | - | - | - | - | - | - | - | - | - | - |
| 2,2-Bis-hydroxymethyl-propionsäure | 11,35 | 12,34 | 12,8 | 18,1 | 7,99 | 10,94 | 22,96 | 18,45 | 22,56 | 10,23 | - |
| Polypropylenglykol (M = 480) | 40,63 | 44,16 | 34,37 | 21,59 | 28,59 | 39,18 | 27,4 | 16,49 | 26,9 | 36,64 | 28,09 |
| 2,2-Bis-(4-hydroxyethoxy-phenyl)-propan | - | - | 8,19 | - | - | - | - | 3,92 | - | - | - |
| 2,4-Dihydroxybenzoesäure | - | - | - | - | - | - | - | - | - | - | 9,01 |
| Polyoxypropylendiamin (M = 420) | 8,14 | 8,13 | 8,08 | 8,16 | - | 8,14 | 8,15 | 8,14 | 8,14 | 8,14 | - |
| Polyoxypropylendiamin (M = 2000) | - | - | - | - | 30,11 | - | - | - | - | - | 30,12 |
| Säurezahl | 46 | 51 | 53 | 75 | 32 | 45 | 95 | 76 | 93 | 42 | 32 |
| Reaktionszeit (Stunden) | 8 | 7 | 9,5 | 20 | 1,5 | 35 | 30 | 15 | 11 | 15 | 12 |

Anwendungsbeispiel 1

Eine Beschichtungslösung aus

| | |
|---|---|
| 18,1 Gt | der 20 %igen Polymerlösung aus Synthesebeispiel 2, |
| 3,6 Gt | Trimethylolethantriacrylat, |
| 0,02 Gt | Tris-(4-dimethylaminophenyl)-methan, |
| 0,123 Gt | 2-(4-Styrylphenyl)-4,6-bis-trichlormethyl-s-triazin, |
| 0,073 Gt | eines blauen Azofarbstoffs, hergestellt durch Kuppeln von 2,4-Dinitro-6-chlor-benzoldiazoniumchlorid mit 2-Methoxy-5-acetylamino-N,N-diethylanilin und |
| 0,036 Gt | Farbstoff C.I. Disperse Red 179 in |
| 75,0 Gt | Propylenglykolmonomethylether |

wurde auf eine 0,3 mm starke Aluminiumfolie, die in einer wäßrigen Lösung von Salpetersäure elektrochemisch aufgerauht, in einem schwefelsauren Bad anodisiert und danach mit einer 0,1 %igen wäßrigen Lösung von Polyvinylphosphonsäure hydrophiliert worden war, aufgebracht und anschließend 2 Minuten im Umlufttrockenschrank getrocknet (Trockenschichtgewicht = 2,5 g/qm). Die Platte wurde danach mit einer 15 %igen wäßrigen Lösung von Polyvinylalkohol (12 % Restacetylgruppen, K-Wert 4) beschichtet. Die erhaltene Druckplatte wurde 10 Sekunden mittels einer 5 kW Metallhalogenidlampe im Abstand von 110 cm unter einem 13-stufigen Belichtungskeil mit Dichteinkrementen von 0,15 belichtet. Die Platte wurde anschließend mit einer Lösung aus

| | |
|---|---|
| 8,5 Gt | $Na_2SiO_3$ x 9 $H_2O$, |
| 0,8 Gt | NaOH und |
| 1,5 Gt | $Na_2B_4O_7$ x 10 $H_2O$ in |
| 89,2 | Gt Wasser |

entwickelt. Die Stufe 4 des Halbtonstufenkeils war gedeckt.

Anwendungsbeispiel 2 (Vergleichsbeispiel)

Eine Flachdruckplatte wurde nach den Angaben im Anwendungsbeispiel 1 hergestellt, jedoch wurde statt der Polymerlösung aus Synthesebeispiel 2 die Lösung aus Synthesebeispiel 1 benutzt. Es wurde der gleiche Entwickler wie im Anwendungsbeispiel 1 verwendet.

Um die Stufe 4 im Halbtonstufenkeil gedeckt zu erhalten, mußte die Platte 40 Sekunden belichtet werden. Die Druckauflage dieser Platte war nur halb so hoch wie die Auflage der Flachdruckplatte aus Anwendungsbeispiel 1.

Anwendungsbeispiele 3 bis 11

Die Flachdruckplatten der Beispiele 3 bis 11 wurden analog dem Anwendungsbeispiel 1 hergestellt, entsprechend belichtet und entwickelt. Zusammensetzung, Belichtungszeit und Entwickelbarkeit sind in Tabelle 2 aufgelistet.

Tabelle 2 Die Zahlenangaben entsprechen Gewichtsteilen, soweit nichts anderes angegeben

| Anwendungsbeispiel | 3 | 4 | 5 | 6 | 7 | 8 | 9 | 10 | 11 |
|---|---|---|---|---|---|---|---|---|---|
| Bindemittel *) | 6 | 3 | 2 | 6 | 3 | 5 | 5 | 6 | 3 |
| Trimethylolethantriacrylat | - | 1,8 | 1,8 | 1,8 | - | - | 1,8 | 1,8 | - |
| Pentaerytrittriacrylat | 1,8 | - | - | - | 1,8 | 1,8 | - | - | 1,8 |
| Diurethan **) | 1,8 | 1,8 | 1,8 | 1,8 | 1,8 | 1,8 | 1,8 | 1,8 | 1,8 |
| 2-(4-Styryl-phenyl)-4,6-bis-trichlor-methyl-s-triazin | 0,12 | 0,12 | 0,12 | 0,12 | 0,12 | 0,12 | 0,12 | 0,12 | 0,12 |
| blauer Azofarbstoff gemäß Anwendungs-beispiel 1 | 0,073 | 0,073 | 0,073 | 0,073 | 0,073 | 0,073 | 0,073 | 0,073 | 0,073 |
| C.I. Disperse Red 179 | 0,036 | 0,036 | 0,036 | 0,036 | 0,036 | 0,036 | 0,036 | 0,036 | 0,036 |
| 4-Diethylamino-4'-methoxy-dibenzalaceton | - | 0,05 | - | 0,10 | 0,20 | - | 0,1 | 0,05 | 0,05 |
| Tris-(4-dimethylamino-phenyl)-methan | 0,02 | 0,02 | 0,02 | 0,02 | 0,02 | 0,02 | 0,02 | 0,02 | 0,02 |
| 2-Methoxy-propanol | 100,0 | 100,0 | 100,0 | 100,0 | 100,0 | 100,0 | 100,0 | 100,0 | 100,0 |
| Belichtungszeit (s) | 20 | 15 | 10 | 20 | 20 | 7 | 20 | 15 | 10 |
| Entwickelbarkeit | mäßig | gut | gut | gut | gut | gut | gut | gut | gut |
| Taberabrieb ***) | 0,12 | 0,10 | 0,22 | 0,05 | 0,06 | 0,11 | 0,14 | 0,09 | 0,11 |

*) jeweils 12 g 30 %ige Lösung in Tetrahydrofuran.
Die Zahlen bedeuten die Nummern des Herstellungsbeispiels für das Polymere.

**) aus 2 mol Hydroxyethylmethacrylat und 1 mol 2,4,4-Trimethyl-hexamethylendiisocyanat

***) Gewichtsverlust in g/m2, bestimmt an einer auf einem rotierenden Plattenteller montierten Probe, gegen die zwei Schmirgelrollen gedrückt werden, nach 20 Umdrehungen.
Verfahren analog ASTM D 1300

## Patentansprüche

1. Durch Strahlung polymerisierbares Gemisch, das als wesentliche Bestandteile
   a) ein gesättigtes Polymeres mit wiederkehrenden Urethangruppen und Harnstoffgruppen in der Hauptkette, das
      α) Einheiten, die aus einem Carboxylgruppen enthaltenden Diol,
      β) Einheiten, die aus einem Diamin und
      γ) Einheiten enthält, die aus einem Diisocyanat entstanden sind,
   b) eine radikalisch polymerisierbare Verbindung mit mindestens einer end-ständigen ethylenischen Doppelbindung und einem Siedepunkt oberhalb 100 °C bei Normaldruck und
   c) eine Verbindung oder eine Verbindungskombination enthält, die unter Einwirkung von aktinischer Strahlung die Polymerisation der Verbindung (b) zu initieren vermag,

   dadurch gekennzeichnet, daß die Diamineinheiten von einem Polyether- oder Polyesterdiamin abgeleitet sind.

2. Gemisch nach Anspruch 1, dadurch gekennzeichnet, daß in dem gesättigten Polymeren a) ein Verhältnis von Harnstoff- zu Urethangruppen im Bereich von 1 : 99 bis 95 : 5 mol-% vorliegt.

3. Gemisch nach Anspruch 1, dadurch gekennzeichnet, daß das gesättigte Polymere a) zusätzlich Einheiten eines von Carboxylgruppen freien Diols enthält.

4. Gemisch nach Anspruch 3, dadurch gekennzeichnet, daß das Diol ein Polyetherdiol ist.

5. Gemisch nach Anspruch 1, dadurch gekennzeichnet, daß das gesättigte Polymere a) eine Säurezahl im Bereich von 5 bis 200 hat.

6. Gemisch nach Anspruch 1, dadurch gekennzeichnet, daß das gesättigte Polymere a) ein mittleres Molekulargewicht $M_w$ von 10.000 bis 200.000 aufweist.

7. Gemisch nach Anspruch 1, dadurch gekennzeichnet, daß das gesättigte Polymere a) durch Umsetzen eines Carboxylgruppen enthaltenden Diols mit einem Überschuß an Diisocyanat und Umsetzen des Reaktionsprodukts mit einem Diamin erhalten worden ist.

8. Gemisch nach Anspruch 1, dadurch gekennzeichnet, daß die polymerisierbare Verbindung ein Ester der Acryl- oder Methacrylsäure mit einem aliphatischen Alkohol ist.

9. Gemisch nach Anspruch 1, dadurch gekennzeichnet, daß die polymerisierbare Verbindung mindestens zwei polymerisierbare Gruppen enthält.

10. Durch Strahlung polymerisierbares Aufzeichnungsmaterial mit einem Schichtträger und einer durch Strahlung polymerisierbaren Schicht, dadurch gekennzeichnet, daß die Schicht aus einem Gemisch gemäß Anspruch 1 besteht.

11. Aufzeichnungsmaterial nach Anspruch 10, dadurch gekennzeichnet, daß auf der durch Strahlung polymerisierbaren Schicht eine für Sauerstoff wenig durchlässige transparente Deckschicht angeordnet ist.

## Claims

1. A radiation-polymerizable mixture which contains, as essential constituents,
   a) a saturated polymer containing repeating urethane groups and urea groups in its main chain, said polymer containing
      α) units which are produced from a diol containing carboxyl groups,
      β) units which are produced from a diamine, and
      γ) units which are produced from a diisocyanate,
   b) a free radical-polymerizable compound containing at least one terminal olefinic double bond and having a boiling point above 100 °C at normal pressure, and
   c) a compound or a combination of compounds which are capable of initiating the polymerization of

the compound (b) on exposure to actinic radiation,
wherein the diamine units are derived from a polyether diamine or polyester diamine.

2. The mixture as claimed in claim 1, wherein, in the saturated polymer a), the ratio of urea groups to urethane groups is in the range from 1:99 mole % to 95:5 mole %.

3. The mixture as claimed in claim 1, wherein the saturated polymer a) additionally contains units of a diol free from carboxyl groups.

4. The mixture as claimed in claim 3, wherein the diol is a polyether diol.

5. The mixture as claimed in claim 1, wherein the saturated polymer a) has an acid number in the range from 5 to 200.

6. The mixture as claimed in claim 1, wherein the saturated polymer a) has a mean molecular weight $M_w$ of 10,000 to 200,000.

7. The mixture as claimed in claim 1, wherein the saturated polymer a) has been obtained by reacting a diol containing carboxyl groups with an excess of diisocyanate and reacting the reaction product with an excess of diamine.

8. The mixture as claimed in claim 1, wherein the polymerizable compound is an ester of acrylic acid or methacrylic acid with an aliphatic alcohol.

9. The mixture as claimed in claim 1, wherein the polymerizable compound contains at least two polymerizable groups.

10. Radiation-polymerizable recording material comprising a layer support and a radiation-polymerizable layer wherein said layer is comprised of a mixture as claimed in claim 1.

11. The copying material as claimed in claim 10, wherein a transparent top layer with low oxygen permeability is disposed on the radiation-polymerizable layer.

## Revendications

1. Composition polymérisable par irradiation, contenant, en tant que composants essentiels
   a) un polymère saturé à groupes urée et groupes uréthanne répétitifs dans la chaîne principale, qui contient
      α) des motifs qui proviennent d'un diol comportant des groupes carboxy,
      β) des motifs qui proviennent d'une diamine et
      γ) des motifs qui proviennent d'un diisocyanate,
   b) un composé polymérisable par polymérisation radicalaire, comportant au moins une double liaison éthylénique en bout de chaîne et ayant un point d'ébullition de plus de 100 °C sous la pression normale, et
   c) un composé ou une association de composés permettant, sous l'effet d'un rayonnement actinique, d'amorcer la polymérisation du composé b),
   caractérisée en ce que les motifs diamine sont dérivés d'une polyester- ou polyétherdiamine.

2. Composition selon la revendication 1, caractérisée en ce que, dans le polymère saturé a), il existe un rapport des groupes urée aux groupes uréthanne dans la plage allant de 1:99 à 95:5 % en moles.

3. Composition selon la revendication 1, caractérisée en ce que le polymère saturé a) contient en outre des motifs d'un diol exempt de groupes carboxy.

4. Composition selon la revendication 3, caractérisée en ce que le diol est un polyétherdiol.

5. Composition selon la revendication 1, caractérisée en ce que le polymère saturé a) a un indice d'acide

dans la plage allant de 5 à 200.

6. Composition selon la revendication 1, caractérisée en ce que le polymère saturé a) présente une masse moléculaire moyenne $\overline{M}_p$ de 10 000 à 200 000.

7. Composition selon la revendication 1, caractérisée en ce que le polymère saturé a) a été obtenu par la réaction d'un diol comportant des groupes carboxy avec un excès de diisocyanate, et la réaction avec une diamine du produit de réaction.

8. Composition selon la revendication 1, caractérisée en ce que le composé polymérisable est un ester de l'acide acrylique ou méthacrylique avec un alcool aliphatique.

9. Composition selon la revendication 1, caractérisée en ce que le composé polymérisable contient au moins deux groupes polymérisables.

10. Matériau de reprographie polymérisable par irradiation, comportant un support de couche et une couche polymérisable par irradiation, caractérisé en ce que la couche consiste en une composition selon la revendication 1.

11. Matériau de reprographie selon la revendication 10, caractérisé en ce qu'une couche transparente de recouvrement, peu perméable à l'oxygène, est disposée sur la couche polymérisable par irradiation.